# FASCICULE DE BREVET EUROPEEN

(11) **EP 2 451 740 B1**
(45) Date de publication et mention de la délivrance du brevet: **30.10.2013**
(21) Numéro de dépôt: 10731511.1
(22) Date de dépôt: 06.07.2010
(51) Int. Cl.: B81C 1/00

(54) **CAVITE ETANCHE ET PROCEDE DE REALISATION D'UNE TELLE CAVITE ETANCHE.**
VERSIEGELTE KAVITÄT UND VERFAHREN ZUR HERSTELLUNG EINER DERARTIGEN VERSIEGELTEN KAVITÄT
SEALED CAVITY AND METHOD FOR MAKING SUCH A SEALED CAVITY

(30) Priorité: 07.07.2009 FR 0954684
(43) Date de publication de la demande: 16.05.2012
(73) Titulaire: COMMISSARIAT A L'ENERGIE ATOMIQUE ET AUX ENERGIES ALTERNATIVES, 75015 Paris (FR)
(72) Inventeur: PORNIN, Jean-Louis, F-38920 Crolles (FR); JACQUET, Fabrice, F-38220 Saint Pierre De Mesage (FR)
(74) Mandataire: Ilgart, Jean-Christophe
(86) Numéro de dépôt international: PCT/EP2010/059640
(87) Numéro de publication internationale: WO 2011/003908

(56) Documents cités:
- US-A1- 2003 183 916
- US-A1- 2006 267 109

## Description

### DOMAINE TECHNIQUE

L'invention concerne la réalisation d'une cavité étanche vis-à-vis de fluides et/ou de gaz, par exemple mise en oeuvre pour une encapsulation d'un dispositif microélectronique, et plus particulièrement une encapsulation sous vide en couches minces de dispositifs de type MEMS (microsystème électromécanique) ou MEOMS (microsystème électro-optico-mécanique), ou encore de type NEMS (nanosystème électromécanique). Dans la suite de ce document, le terme « MEMS » sera utilisé pour désigner un dispositif de type MEMS, NEMS ou MEOMS.

L'invention s'applique également pour la réalisation d'une cavité formant un canal de circulation de fluides liquides ou gazeux.

### ÉTAT DE LA TECHNIQUE ANTÉRIEURE

La technique d'encapsulation (« packaging ») en couches minces, également appelée PCM, est parfaitement adaptée pour réaliser une encapsulation de dispositifs microélectroniques de type MEMS, par exemple des capteurs, fonctionnant à pression atmosphérique. Lors de la mise en oeuvre de ce type d'encapsulation, on recouvre le dispositif MEMS d'une couche sacrificielle, cette couche sacrificielle étant ensuite recouverte par une couche mince d'épaisseur comprise entre environ 1 µm et 5 µm, destinée à former un capot. Des trous de libération sont ensuite réalisés à travers le sommet du capot, formant ainsi des accès pour graver la couche sacrificielle. Un tel procédé est connu par exemple de US 2003/0183916.

On obtient ainsi une cavité dans laquelle le dispositif MEMS est encapsulé. Le bouchage des trous de libération se fait alors par un dépôt de polymère venant boucher les trous sans passer à travers les trous.

De plus en plus de dispositifs MEMS, par exemple des accéléromètres, des gyromètres ou des détecteurs optiques, fonctionnent sous pression réduite ou sous vide, c'est-à-dire à des pressions comprises entre environ 900 mbar et 1.10⁻³ mbar.

Dans ce cas, le bouchage des trous de libération par un dépôt de polymère est incompatible avec la réalisation d'une cavité à pression réduite ou sous vide.

Il est connu de mettre en oeuvre des procèdes d'encapsulation sous vide dans lesquels le bouchage des trous de libération est obtenu par fusion d'alliage sur une surface mouillable autour des trous de libération, formant des billes à base de cet alliage au-dessus de ces trous de libération. Ce procédé nécessite toutefois la mise en oeuvre de plusieurs étapes technologiques. De plus, la refusion de l'alliage sous vide impose une préparation de cet alliage complexe à mettre en oeuvre si on veut éviter la présence de gaz résiduels agressifs dans la cavité ou incompatibles avec la pression souhaitée.

Si l'on souhaite boucher les trous de libération par un dépôt sous vide ou sous pression réduite d'une couche de bouchage à base d'un matériau adapté tel qu'un diélectrique ou un métal, de la matière issue de ce dépôt risque de traverser les trous et venir se déposer sur la partie active, c'est-à-dire sur le dispositif MEMS, ce qui pourrait perturber ou empêcher le fonctionnement du dispositif MEMS.

Pour résoudre ce problème, le document WO 2006/081636 A1 décrit un procédé d'encapsulation dans lequel le capot est formé par une couche poreuse, les pores formant des trous de libération très fins (diamètres des trous inférieurs à environ 500 nm) avec un rapport profondeur / diamètre important.

Ce procédé permet d'éviter que de la matière issue d'une couche de bouchage formée au-dessus du capot ne se dépose sur le dispositif MEMS.

Il est également connu de déporter les trous de libération vers l'extérieur de la cavité. Dans ce cas, la hauteur des trous à boucher est importante car celle-ci est égale à la hauteur de la cavité.

Il est également connu de définir des canaux de libération de faible épaisseur sur les côtés de la cavité principale. Dans ce cas, lorsque la hauteur à boucher est faible, la vitesse de libération est alors fortement réduite.

Il est également connu de réaliser les trous de libération sous forme de chicanes grâce à la réalisation d'un capot à double parois, comme cela est par exemple décrit dans le document US 2008/0079142 A1.

Ces procédés ont toutefois pour inconvénients de nécessiter un espace important, de rendre plus complexe, et donc plus cher, le procédé d'encapsulation, et/ou encore de limiter fortement la vitesse du bouchage et les possibilités de libération de la couche sacrificielle.

### EXPOSÉ DE L'INVENTION

Un but de la présente invention est de proposer un procédé de réalisation de cavité étanche, ou hermétique, vis-à-vis d'au moins un fluide et/ou d'un gaz, pouvant être mis en oeuvre pour réaliser par exemple une encapsulation d'un dispositif microélectronique, par exemple de type MEMS, qui soit compatible pour former une cavité étanche sous pression réduite ou sous vide, et qui ne présente pas les inconvénients des procédés d'encapsulation de l'art antérieur précédemment décrits.

Il est proposé un procédé de réalisation d'au moins une cavité étanche, ou hermétique, selon la revendication 1.

Le terme « substrat » est utilisé ici au sens large et peut désigner une couche seule ou un empilement de plusieurs couches, structurées ou non, par exemple dans le cas d'un substrat SOI (semi-conducteur sur isolant) où la couche supérieure de silicium comporterait la face sur laquelle la couche sacrificielle est réalisée.

Ce procédé permet de réaliser un ou plusieurs trous de libération en ne faisant appel qu'à un seul niveau de photolithographie, contrairement aux trous de libération réalisés sous forme de chicanes dans un capot à double parois ou de canaux déportés.

De plus, en choisissant la hauteur du ou des trous de libération, c'est-à-dire la distance, selon un axe perpendiculaire à la face du substrat, entre ladite face du substrat et le plus haut point du ou des trous se trouvant du côté de la face de la couche capot disposée contre la couche sacrificielle, correspondant à la distance maximale, selon un axe perpendiculaire à ladite face du substrat, entre ladite face du substrat et au moins un bord du ou des trous se trouvant du côté d'une face de la couche capot disposée contre la couche sacrificielle, il est possible de choisir la vitesse de libération souhaitée, c'est-à-dire de la vitesse à laquelle est éliminée la couche sacrificielle, en fonction de la technique de bouchage du ou des trous de libération utilisée. La hauteur souhaitée peut par exemple être obtenue en choisissant l'angle formé par les flancs latéraux, ou parois latérales, de la couche capot, la position du ou des trous de libération sur les flancs latéraux de la couche capot ou encore les dimensions et/ou la forme du ou des trous de libération. Ainsi, il est possible d'éliminer rapidement la couche sacrificielle en réalisant un ou plusieurs trous comportant des sections de passage importantes et/ou en réalisant un nombre de trous importants.

Ce procédé offre également une liberté de positionnement du ou des trous de libération sans que cela soit préjudiciable par la suite lors du bouchage du ou des trous.

De plus, contrairement aux procédés de l'art antérieur faisant appel à des canaux déportés par rapport à la cavité pour former des accès à une couche sacrificielle, ce procédé permet d'avoir un angle solide efficace du passage des gaz qui augmente dès que l'élimination de la couche sacrificielle commence.

Ce procédé s'intègre parfaitement dans l'optique d'une encapsulation au niveau du wafer (plaquette comportant plusieurs dispositifs microélectroniques) permettant la mise en oeuvre d'une encapsulation collective des dispositifs et une faible consommation de surface de semi-conducteur du wafer.

L'étape c) de réalisation du trou peut correspondre à une étape de réalisation d'au moins un trou à travers les flancs latéraux de la couche capot, une partie supérieure, ou sommitale, de la couche capot recouvrant la couche sacrificielle pouvant être conservée sans trou.

La valeur de l'angle formé par les flancs latéraux de la couche capot avec la partie de la face du substrat recouverte par la couche sacrificielle peut être comprise entre environ 5° et 30°.

Dans une variante, l'épaisseur de la couche sacrificielle peut être comprise entre environ 0,5 µm et 1 µm et la valeur de l'angle formé par les flancs latéraux de la couche capot avec la partie de la face du substrat recouverte par la couche sacrificielle peut être comprise entre environ 45° et 90°.

La distance maximale, selon un axe perpendiculaire à ladite face du substrat, entre ladite face du substrat et les bords du trou peut être comprise entre environ 1 µm et 3 µm, ou entre environ 1 µm et 5 µm.

L'étape b) de réalisation de la couche capot peut correspondre à la mise en oeuvre, après l'étape a) de réalisation de la couche sacrificielle, d'une mise en forme, ou structuration, de la couche sacrificielle telle que des flancs latéraux de la couche sacrificielle forment, avec la partie de la face du substrat recouverte par la couche sacrificielle, l'angle inférieur à 90°, puis à un dépôt conforme de la couche capot au moins sur la couche sacrificielle.

La couche capot réalisée à l'étape b) recouvre également une partie de la face du substrat qui est non recouverte par la couche sacrificielle et adjacente à la partie de la face du substrat recouverte par la couche sacrificielle, le trou réalisé à l'étape c) traversant également une partie de la couche capot déposée sur la partie de la face du substrat qui est non recouverte par la couche sacrificielle. Ainsi, il est possible d'avoir un ou plusieurs trous débordants sur la partie extérieure de la cavité ou tangents à cette partie extérieure (et donc tangents à la face du substrat), formant des trous périphériques au niveau de la base de la couche capot en contact avec le substrat. Dans cette configuration, lors de l'élimination de la couche sacrificielle, la section de libération augmente donc au fur et à mesure de l'avancement de cette élimination de la couche sacrificielle, ce qui se traduit par une diminution des pertes de charge lors de l'avancement de l'élimination. Une élimination de la couche sacrificielle à travers un ou plusieurs trous ainsi formés est donc plus rapide qu'une élimination à travers un trou débouchant dans un canal de section constante avant d'aboutir à la cavité car un tel canal implique des pertes de charge permanentes.

Le trou réalisé à l'étape c) peut comporter, dans un plan de la face de la couche capot disposée contre la couche sacrificielle, une section de dimensions inférieures à celles d'une section du trou dans un plan d'une seconde face de la couche capot opposée à ladite face disposée contre la couche sacrificielle.

L'étape e) de dépôt du matériau bouchant de manière étanche, ou hermétiquement, le trou peut être mise en oeuvre sous pression réduite ou sous vide, c'est-à-dire à des pressions comprises entre environ 1.10⁻³ mbar et 900 mbar.

L'étape e) de dépôt du matériau bouchant de manière étanche le trou peut comporter la mise en oeuvre d'un premier dépôt d'au moins un premier matériau bouchant partiellement le trou, et d'un second dépôt d'au moins un second matériau recouvrant au moins en partie le premier matériau et bouchant de manière étanche le trou. Ainsi, il est possible d'utiliser plusieurs matériaux différents pour fermer de manière étanche la cavité, par exemple sous très basse pression (par exemple inférieure à environ 1.10⁻³ mbar.

Le trou réalisé à l'étape c) peut comporter, dans un plan d'une face de la couche capot, une section de forme sensiblement circulaire ou oblongue. Dans le cas d'une section de forme oblongue, le rapport longueur/largeur de la section (la longueur correspondant à la dimension parallèle à un axe appartenant au dit plan de la face de la couche capot tel que la distance entre cet axe et le substrat est sensiblement constante) peut être choisi relativement grand, c'est à dire supérieur à 1 et par exemple compris entre environ 1 et 15, de façon à créer des lumières, ou sections de passage, suffisamment importantes pour permettre d'optimiser la vitesse de libération, c'est-à-dire la vitesse d'élimination de la couche sacrificielle, sans augmenter la hauteur du trou de libération à boucher par rapport au substrat.

Préalablement à l'étape a), un dispositif microélectronique peut être réalisé sur ou dans ladite partie de la face du substrat destinée à être recouverte par la couche sacrificielle, ledit dispositif microélectronique pouvant être encapsulé de manière étanche dans la cavité après la mise en oeuvre de l'étape e) de dépôt du matériau bouchant de manière étanche le trou.

Le dispositif microélectronique peut être de type MEMS.

Dans une variante, la cavité peut former un canal de circulation de fluides liquides ou gazeux.

Il est également proposé une cavité étanche formée par au moins une couche capot disposée sur une face d'un substrat, la couche capot comportant des flancs latéraux formant, avec une partie de la face du substrat disposée dans la cavité, au moins un angle inférieur à 90°, au moins un trou étant réalisé à travers au moins un des flancs latéraux de la couche capot tel qu'une distance maximale, selon un axe perpendiculaire à ladite face du substrat, entre ladite face du substrat et au moins un bord du trou se trouvant du côté d'une face de la couche capot formant une paroi de la cavité, soit inférieure à environ 3 µm, au moins un matériau bouchant de manière étanche le trou.

Une partie sommitale de la couche capot peut être conservée sans trou.

La valeur de l'angle formé par les flancs latéraux de la couche capot avec la partie de la face du substrat disposée dans la cavité peut être comprise entre environ 5° et 30°.

Dans une variante, une distance entre la partie sommitale de la couche capot et le substrat peut être comprise entre environ 0,5 µm et 1 µm, et la valeur de l'angle formé par les flancs latéraux de la couche capot avec la partie de la face du substrat disposée dans la cavité peut être comprise entre environ 45° et 90°.

La couche capot peut recouvrir également au moins une partie de la face du substrat qui n'est pas disposée dans la cavité et adjacente à la partie de la face du substrat disposée dans la cavité, le trou pouvant traverser également une partie de la couche capot déposée sur la partie de la face du substrat qui est n'est pas disposée dans la cavité.

Au moins un dispositif microélectronique peut être encapsulé de manière étanche dans la cavité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

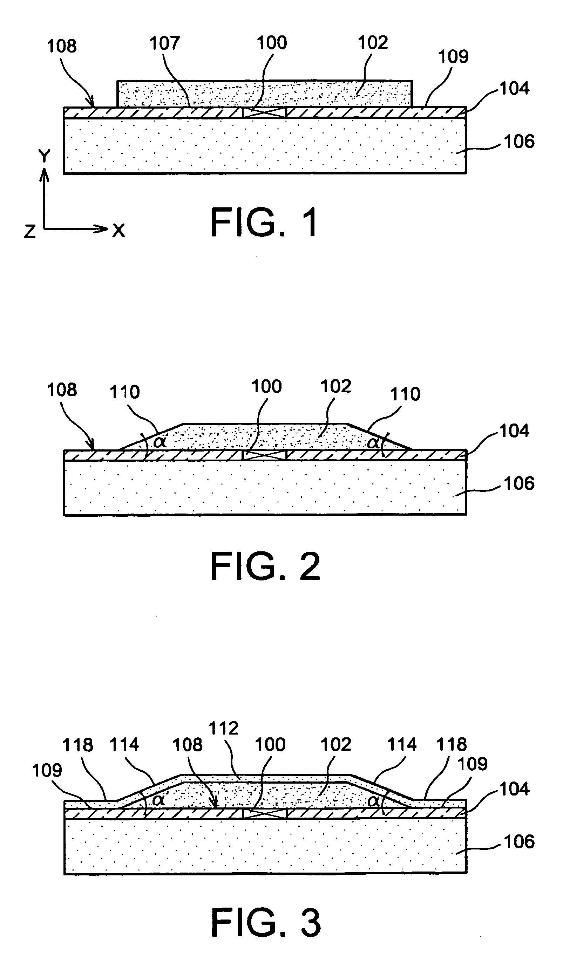

- les figures 1 à 9 représentent les étapes d'un procédé de réalisation d'une cavité hermétique, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord aux figures 1 à 9 qui représentent les étapes d'un procédé de réalisation d'une cavité hermétique 120 selon un mode de réalisation particulier. Ce mode de réalisation correspond à un procédé d'encapsulation d'un dispositif microélectronique 100, par exemple de type MEMS tel qu'un accéléromètre, un gyromètre ou un détecteur optique, dans cette cavité 120.

Comme représenté sur la figure 1, on réalise tout d'abord, par exemple par dépôt et gravure, une couche sacrificielle 102 recouvrant le dispositif 100. Dans ce mode de réalisation particulier, la couche sacrificielle 102 est à base de polymère et a une épaisseur (dimension selon l'axe y représenté sur la figure 1) pouvant être comprise entre environ 1 µm et 10 µm. La couche sacrificielle 102 recouvre une partie 107 d'une face 108 d'une couche active 104, par exemple à base de semi-conducteur tel que du silicium, dans laquelle le dispositif 100 est réalisé, cette couche active 104 étant disposée sur une couche diélectrique 106.

La couche sacrificielle 102 est ensuite mise en forme, ou structurée, par exemple par la mise en oeuvre d'un traitement thermique sous forme de recuits avec des paliers à différentes températures. Ce traitement thermique correspond par exemple à une montée en température depuis la température ambiante jusqu'à une température égale à environ 300°C. Des paliers de maintien à température d'une durée égale à environ 15 mn sont par exemple réalisés tous les 100°C. L'ensemble est ensuite ramené linéairement à température ambiante, sans palier. Cette mise en forme peut également être réalisée par une gravure en pente de la couche sacrificielle 102, ou encore, lorsque la couche sacrificielle 102 est à base d'un matériau photosensible, par une insolation avec un « masque à niveaux de gris » permettant de réaliser une insolation de la couche sacrificielle 102 telle que, lorsque la couche sacrificielle 102 est à base de résine positive, le flux lumineux atteignant la couche sacrificielle 102 diminue lorsque la distance depuis le bord de la couche sacrificielle 102 augmente.

Des flancs latéraux 110 de cette couche sacrificielle 102 forment, avec la surface sur laquelle est disposée la couche sacrificielle 102, c'est-à-dire ici la partie 107 de la face 108 de la couche active 104, un angle α inférieur à 90° (voir figure 2).

La couche sacrificielle 102 est par exemple structurée afin que l'angle α soit compris entre environ 5° et 30°.

Le volume de la couche sacrificielle 102 ainsi structurée correspond sensiblement au volume de la cavité dans laquelle le dispositif 100 sera encapsulé à la fin de ce procédé.

Comme représenté sur la figure 3, on réalise un dépôt conforme d'un matériau formant une couche capot 112 destinée à former le capot de la cavité dans laquelle le dispositif 100 est destiné à être encapsulé.

La couche capot 112 recouvre ainsi la couche sacrificielle 102 ainsi que des parties 109 de la couche active 104 non recouvertes par la couche sacrificielle 102. Ainsi, la couche capot 112 comporte également des flancs latéraux 114 formant, avec la partie 107 de la face 108 de la couche active 104 sur laquelle est disposée la couche sacrificielle 102, un angle α inférieur à 90°, et par exemple compris entre environ 5° et 30°.

Cette couche capot 112 est par exemple à base d'un matériau diélectrique tel que du SiO₂ ou du SiN, mais peut également être à base d'un matériau semi-conducteur tel que du silicium ou encore d'un métal.

L'épaisseur de la couche capot 112 est par exemple comprise entre environ 1 µm et 5 µm.

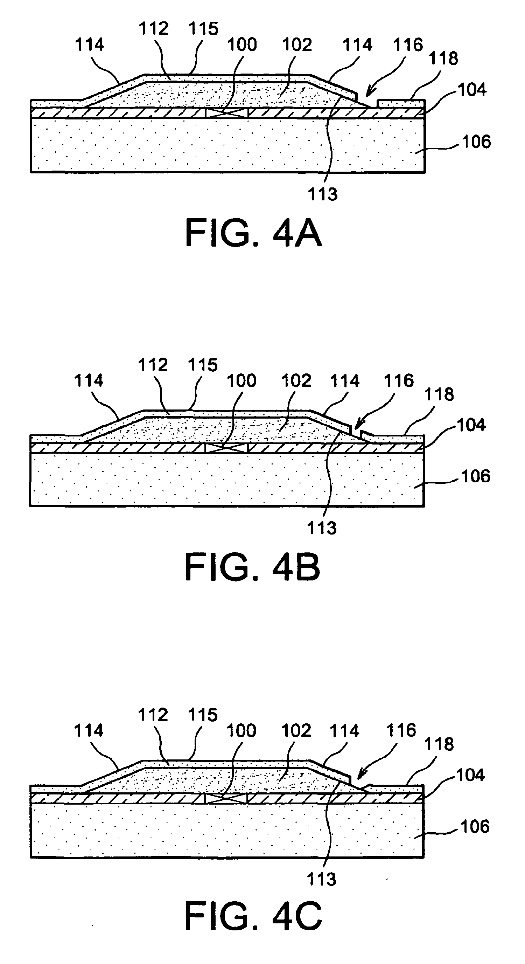

On réalise ensuite à travers la couche capot 112 un ou plusieurs trous 116, formant des accès à la couche sacrificielle 102 (voir figure 4A, sur laquelle un seul trou 116 est représenté).

Ces trous de libération 116 sont réalisés au niveau de la périphérie de la couche sacrificielle 102 afin d'accéder aux flancs latéraux 110 de la couche sacrificielle 102. Aucun trou de libération n'est réalisé à travers une partie sommitale 115, ou partie supérieure, de la couche capot 112.

Dans la mode de réalisation de la figure 4A, les trous de libération 116 sont réalisés afin de traverser une partie des flancs latéraux 114 de la couche capot 112 ainsi que des parties 118 de la couche capot 112 ne recouvrant pas la couche sacrificielle 102, c'est-à-dire déposées sur la couche active 104.

La section de chaque trou de libération 116, dans un plan passant par une des faces de la couche capot 112, est par exemple circulaire, ellipsoïdale, oblongue ou d'une toute autre forme dont le contour ne présente pas d'angle vif ou de rupture au niveau de ses bords.

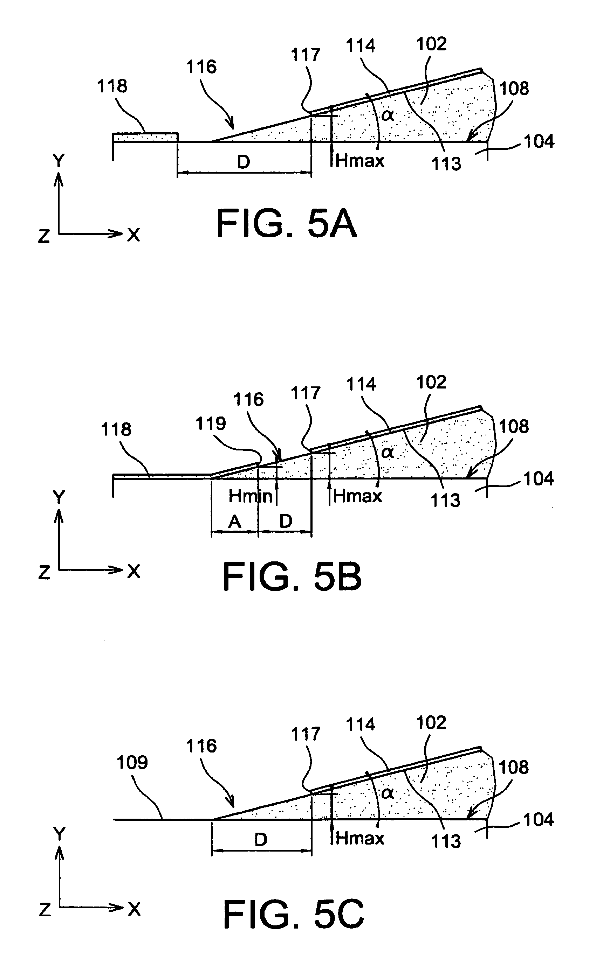

Le trou de libération 116 ainsi réalisé est représenté de manière détaillée sur la figure 5A.

On définit une hauteur Hmax comme étant la hauteur maximale de la portion de la couche sacrificielle 102 mise à nue au niveau du trou de libération 116, et correspond à une distance maximale, selon un axe perpendiculaire à la face 108 de la couche active 104, entre ladite face 108 et l'un des bords 117 des trous 116 au niveau d'une face 113 de la couche capot 112 disposée contre la couche sacrificielle 102.

La valeur de cette hauteur Hmax est déterminée en fonction de la valeur de l'angle α ainsi que de la valeur de la dimension du trou 116 selon l'axe x (axe parallèle à la face 108 de la couche active 104 sur laquelle est déposée la couche sacrificielle 102), et plus particulièrement de la dimension D correspondant à la largeur (selon l'axe x représenté sur la figure 5A) de la partie gravée du flanc latéral 114 à partir de la jonction entre le flanc latéral 114 et la partie 118 de la couche capot 112.

On donne ci-dessous plusieurs exemples de valeurs de la hauteur Hmax obtenues pour un angle α = 7° et pour différents types de trou de libération 116 :

| Dimension D (en µm) | Hauteur Hmax (en µm) |
|---|---|
| 2 | 0,24 |
| 3 | 0,36 |
| 6 | 0,72 |

La figure 4B représente un exemple des trous de libération 116 (un seul trou 116 est représenté sur la figure 4B).

Dans cet exemple ne faisant pas partie de l'invention, les trous de libération 116 ne sont réalisés qu'à travers les flancs latéraux 114 de la couche capot 112, et non à travers les parties 118 de la couche capot 112 ne recouvrant pas la couche sacrificielle 102. La figure 5B représente de manière détaillée l'un des trous de libération 116 réalisés selon cet exemple.

De manière analogue à l'exemple représenté sur la figure 5A, la hauteur Hmax correspond à la hauteur maximale de la portion de la couche sacrificielle 102 mise à nue au niveau du trou de libération 116, c'est-à-dire à une distance maximale, selon un axe perpendiculaire à la face 108 de la couche active 104, entre ladite face 108 et l'un des bords 117 des trous 116 se trouvant du côté de la face 113 de la couche capot 112 disposée contre la couche sacrificielle 102.

De plus, étant donné que le trou de libération 116 n'est réalisé qu'à travers un des flancs latéraux 114 de la couche capot 112, il est possible de définir une hauteur Hmin correspondant à la hauteur minimale de la portion de la couche sacrificielle 102 mise à nue au niveau du trou de libération 116 (par analogie, la hauteur Hmin de l'exemple de la figure 5A correspond à une hauteur nulle).

Les valeurs de ces hauteurs Hmax et Hmin sont donc déterminées en fonction de la valeur de l'angle α, de la valeur de la dimension D du trou 116 selon l'axe x (axe parallèle à la face 108 de la couche active 104 sur laquelle est déposée la couche sacrificielle 102), qui correspond ici à la longueur (dimension selon l'axe x représenté sur la figure 5A) de la partie gravée du flanc latéral 114, ainsi que de la distance A entre la jonction du flanc latéral 114 avec la partie 118 de la couche capot 112 et un bord extérieur 119 du trou de libération 116.

On donne ci-dessous plusieurs exemples de valeurs des hauteurs Hmin et Hmax obtenues pour un angle α = 7° avec une distance A comprise entre 0 et 1 µm, pour différents types de trou de libération 116 :

| D (en µm) | A (en µm) | Hmin (en µm) | Hmax (en µm) |
|---|---|---|---|
| 2 | 1 | 0,12 | 0,24 |
| 3 | 0,5 | 0,06 | 0,42 |
| 4 | 0 | 0 | 0,48 |

L'exemple donné à la dernière ligne du tableau ci-dessus correspond au trou 116 représenté sur la figure 5C. Ce trou 116 est ici tangent à une partie 109 de la face 108 qui n'est pas recouverte par le matériau sacrificiel 102. Sur cet exemple, on voit qu'après la réalisation du trou, aucune portion de la couche capot ne se trouve sur cette partie 109 (contrairement à la portion 118 représentée sur la figure 5A) car l'extrémité du flanc latéral 114 qui reposait sur cette partie 109 a été supprimée lors de la réalisation du trou 116.

Les valeurs de l'angle α et de la dimension D peuvent être choisies afin que la valeur de la hauteur Hmax soit inférieure à environ 3 µm, ou comprise entre environ 1 µm et 3 µm ou entre environ 0,1 µm et 1 µm, ou encore comprise entre environ 2 µm et 3 µm.

La valeur de α peut, par exemple, être comprise entre 45° et 90°, lorsque l'épaisseur de la couche sacrificielle 102 est faible, par exemple comprise entre environ 0,5 µm et 1 µm. La variante de réalisation représentée sur la figure 4B peut notamment être mise en oeuvre lorsque l'on souhaite avoir une hauteur Hmax comprise entre environ 1 µm et 2 µm.

La figure 4C représente une seconde variante de réalisation des trous de libération 116. Les parois des trous 116 au niveau des bords ne sont pas verticales (c'est-à-dire parallèles à l'axe y, ou encore perpendiculaires à la face 108 de la couche active 104) mais inclinées telles que les dimensions de la section des trous 116 au niveau d'une face extérieure de la couche capot 112 soit supérieures aux dimensions de la section des trous 116 au niveau d'une face intérieure de la couche capot 122 qui est en contact avec la couche sacrificielle 102, ou du côté de la couche active 104. Ainsi, les ouvertures formées par les trous 116 au niveau de la face externe de la couche capot 112 offrent une surface de passage plus importante que les ouvertures formées par les trous 116 au niveau de la face interne de la couche capot 112.

Les trous de libération 116 ont donc une forme « d'entonnoir » qui faciliteront par la suite le dépôt d'un matériau de bouchage dans ces trous 116.

Cette réalisation des trous 116 peut s'appliquer à la fois pour des trous de libération réalisés uniquement à travers les flancs latéraux 114 comme sur l'exemple de la figure 4B, ou bien à des trous traversant les flancs latéraux 114 et les parties 118 de la couche capot comme sur l'exemple de la figure 4A et des figures 5A et 5C.

De manière générale, on réalisera les trous de libération 116 afin qu'une distance suffisante sépare les trous de libération 116 du dispositif microélectronique 100 afin que le bouchage ultérieur des trous ne génère pas de dépôts sur le dispositif 100.

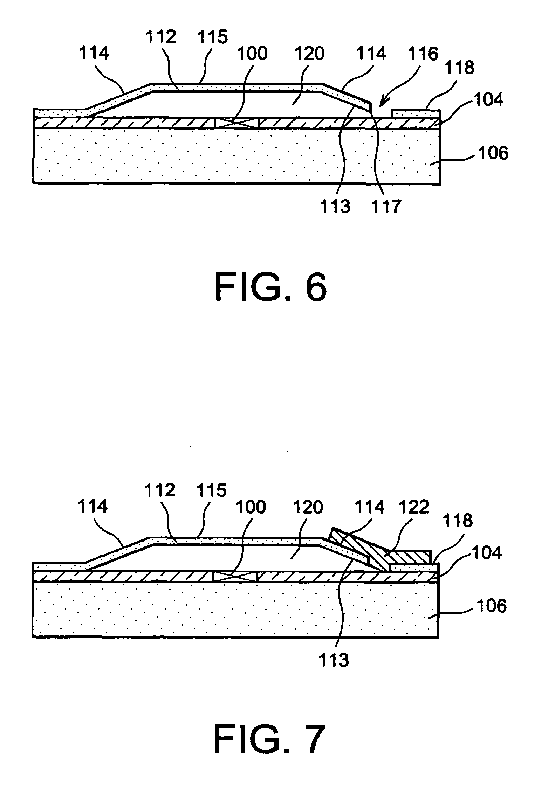

Comme représenté sur la figure 6, on élimine alors la couche sacrificielle 102, par exemple par une gravure sèche à travers les trous de libération 116.

Le volume obtenu par la suppression de la couche sacrificielle 102 forme la cavité 120 dans laquelle le dispositif 100 est encapsulé, la couche capot 112 formant, avec la couche active 104, les parois de cette cavité 120.

Les trous de libération 116 sont ensuite bouchés afin de fermer hermétiquement la cavité 120 (figure 7).

Ce bouchage est par exemple réalisé par le dépôt d'un matériau 122 dans les trous 116, ce matériau 122 pouvant être un diélectrique (par exemple du SiO₂), un métal (par exemple du titane ou de l'aluminium), ou un matériau getter, c'est-à-dire un matériau présentant des propriétés d'absorption et/ou d'adsorption de molécules gazeuses tel que par exemple du chrome et/ou du titane et/ou du zirconium et/ou un alliage de ces matériaux. Le matériau de bouchage 122 est par exemple déposé sous pression réduite, c'est-à-dire à une pression comprise entre environ 1 mbar et 900 mbar lorsque celui-ci est déposé par PECVD (dépôt chimique en phase vapeur assisté par plasma) ou PVD (dépôt physique en phase vapeur), ou sous vide, par exemple à une pression égale à environ 10⁻⁷ mbar, lorsque celui-ci est déposé par exemple par évaporation.

La technique de dépôt du matériau de bouchage 122 est choisie en fonction de l'atmosphère souhaitée dans la cavité 120 (pression réduite ou sous vide) qui sera similaire à l'atmosphère dans laquelle la technique de dépôt du matériau de bouchage 122 est mise en oeuvre.

Ainsi, étant donné que les trous de libération 116 ont été réalisés en périphérie de la couche sacrificielle 102, c'est-à-dire en périphérie de la cavité 120 dans laquelle est encapsulé le dispositif 100, il n'y a donc pas de risque que le matériau de bouchage se dépose sur le dispositif 100 ou ne vienne perturber son fonctionnement.

Lorsque la hauteur Hmax est trop importante, par exemple supérieure à environ 1 µm, pour réaliser le bouchage des trous de libération 116 par un procédé d'évaporation sous vide (par exemple lorsque l'épaisseur maximale pouvant être déposée par cette technique ne permet pas de boucher complètement les trous de libération 116), et/ou que l'on veut une fermeture sous vide poussé de la cavité 120, le bouchage des trous de libération 116 peut être réalisé en au moins deux étapes distinctes.

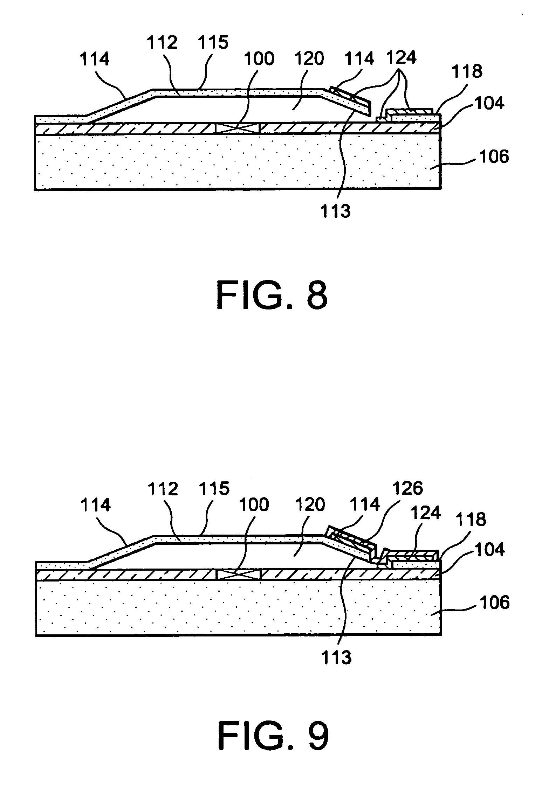

Comme représenté sur la figure 8, les trous de libération 116 sont tout d'abord bouchés partiellement par le dépôt d'un premier matériau de bouchage 124, par exemple déposé par évaporation, PVD ou PECVD.

Un second matériau de bouchage 126 peut ensuite être déposé, par exemple par évaporation sous vide poussé, sur le premier matériau de bouchage 124 afin de fermer hermétiquement la cavité 120 (figure 9). Ainsi, le premier matériau de bouchage 124 permet de combler une partie des trous de libération 116.

L'épaisseur du second matériau de bouchage 126 nécessaire pour réaliser le scellement hermétique de la cavité 120 est donc inférieure à l'épaisseur qui serait nécessaire pour réaliser le bouchage des trous 116 à partir d'un seul matériau de bouchage comme sur la figure 7.

Dans une autre variante, le premier matériau de bouchage 124 pourrait être un matériau getter et le second matériau de bouchage 126 pourrait être un matériau diélectrique ou métallique permettant d'assurer l'étanchéité du bouchage des trous de libération 116.

Dans une autre variante de réalisation, il est possible de réaliser plusieurs trous de libération 116 sur les flancs latéraux 114 de la couche capot 112, disposés à différentes distances du bord du capot formé par cette couche 112, c'est-à-dire à différentes distances de la jonction entre les flancs latéraux 114 et la partie 118 de la couche capot 112.

De plus, on réalise de préférence un maximum de trous de libération 116 dans la couche capot 112 afin de réduire le plus possible le temps nécessaire à la suppression de la couche sacrificielle 102.

Bien que ce procédé de réalisation de cavité étanche et fermée hermétiquement soit particulièrement adapté pour réaliser une cavité sous pression réduite ou sous vide, il est également possible de mettre en oeuvre ce procédé pour réaliser une cavité hermétique dans laquelle la pression correspond à la pression atmosphérique ou à une pression ambiante.

De plus, bien que ce procédé de réalisation d'une cavité hermétique ait été précédemment décrit pour réaliser une encapsulation du dispositif microélectronique 100, ce procédé peut également être mis en oeuvre dans tous les cas où l'on souhaite réaliser une cavité et la boucher sans déposer de matériau de bouchage de manière non contrôlée dans la cavité.

Ce procédé pourrait également s'appliquer à la réalisation d'un canal qui serait formé par la cavité réalisée, et dont le bouchage ne viendrait pas perturber la circulation d'un liquide ou d'un gaz circulant dans ce canal.

## Revendications

1. Procédé de réalisation d'au moins une cavité étanche (120), comportant au moins les étapes suivantes :
a) réalisation d'une couche sacrificielle (102) sur une partie (107) d'une face (108) d'un substrat (104, 106),
b) réalisation d'une couche capot (112) recouvrant au moins la couche sacrificielle (102) et une partie (109) de la face (108) du substrat (104, 106) non recouverte par la couche sacrificielle (102) et adjacente à la partie (107) de la face (108) du substrat (104, 106) recouverte par la couche sacrificielle (102), la couche capot (112) comportant des flancs latéraux (114) formant, avec la partie (107) de la face (108) du substrat (104, 106) recouverte par la couche sacrificielle (102), au moins un angle inférieur à 90°,
c) réalisation d'au moins un trou (116) à travers au moins un des flancs latéraux (114) de la couche capot (112) tel qu'une distance maximale, selon un axe perpendiculaire à ladite face (108) du substrat (104, 106), entre ladite face (108) du substrat (104, 106) et au moins un bord (117) du trou (116) se trouvant du côté d'une face (113) de la couche capot (112) disposée contre la couche sacrificielle (102), soit inférieure à environ 3 µm, le trou (116) traversant une partie (118) de la couche capot (112) déposée sur la partie (109) de la face (108) du substrat (104, 106) qui est non recouverte par la couche sacrificielle (102),
d) élimination de la couche sacrificielle (102) à travers le trou (116), l'espace libéré par cette élimination formant la cavité (120),
e) dépôt d'au moins un matériau (122, 124, 126) bouchant de manière étanche le trou (116).

2. Procédé selon la revendication 1, dans lequel une partie sommitale (115) de la couche capot (112) est conservée sans trou.

3. Procédé selon l'une des revendications précédentes, dans lequel la valeur de l'angle formé par les flancs latéraux (114) de la couche capot (112) avec la partie (107) de la face (108) du substrat (104, 106) recouverte par la couche sacrificielle (102) est comprise entre environ 5° et 30°.

4. Procédé selon l'une des revendications 1 ou 2, dans lequel l'épaisseur de la couche sacrificielle (102) est comprise entre environ 0,5 µm et 1 µm et la valeur de l'angle formé par les flancs latéraux (114) de la couche capot (112) avec la partie (107) de la face (108) du substrat (104, 106) recouverte par la couche sacrificielle (102) est comprise entre environ 45° et 90°.

5. Procédé selon l'une des revendications 1 à 3, dans lequel la distance maximale, selon un axe perpendiculaire à ladite face (108) du substrat (104, 106), entre ladite face (108) du substrat (104, 106) et les bords (117) du trou (116) est comprise entre environ 1 µm et 3 µm.

6. Procédé selon l'une des revendications précédentes, dans lequel l'étape b) de réalisation de la couche capot (112) correspond à la mise en oeuvre, après l'étape a) de réalisation de la couche sacrificielle (102), d'une mise en forme de la couche sacrificielle (102) telle que des flancs latéraux (110) de la couche sacrificielle (102) forment, avec la partie (107) de la face (108) du substrat (104, 106) recouverte par la couche sacrificielle (102), l'angle inférieur à 90°, puis à un dépôt conforme de la couche capot (112) au moins sur la couche sacrificielle (102).

7. Procédé selon l'une des revendications précédentes, dans lequel le trou (116) réalisés à l'étape c) comporte, dans un plan de la face (113) de la couche capot (112) disposée contre la couche sacrificielle (102), une section de dimensions inférieures à celles d'une section du trou (116) dans un plan d'une seconde face de la couche capot (112) opposée à ladite face (113) disposée contre la couche sacrificielle (102).

8. Procédé selon l'une des revendications précédentes, dans lequel l'étape e) de dépôt du matériau (122, 124, 126) bouchant de manière étanche le trou (116) est mise en oeuvre sous pression réduite ou sous vide.

9. Procédé selon l'une des revendications précédentes, dans lequel l'étape e) de dépôt du matériau (124, 126) bouchant de manière étanche le trou (116) comporte la mise en oeuvre d'un premier dépôt d'au moins un premier matériau (124) bouchant partiellement le trou (116), et d'un second dépôt d'au moins un second matériau (126) recouvrant au moins en partie le premier matériau (124) et bouchant de manière étanche le trou (116).

10. Procédé selon l'une des revendications précédentes, dans lequel le trou (116) réalisé à l'étape c) comporte, dans un plan d'une face de la couche capot (112), une section de forme sensiblement circulaire ou oblongue.

11. Procédé selon l'une des revendications précédentes, dans lequel, préalablement à l'étape a), un dispositif microélectronique (100) est réalisé sur ou dans ladite partie (107) de la face (108) du substrat (104, 106) destinée à être recouverte par la couche sacrificielle (102), ledit dispositif microélectronique (100) étant encapsulé de manière étanche dans la cavité (120) après la mise en oeuvre de l'étape e) de dépôt du matériau (122, 124, 126) bouchant de manière étanche le trou (116).

12. Procédé selon la revendication 11, dans lequel le dispositif microélectronique (100) est de type MEMS.

13. Procédé selon l'une des revendications précédentes, dans lequel la cavité (120) forme un canal de circulation de fluides liquides ou gazeux.

14. Cavité étanche (120) formée par au moins une couche capot (112) disposée sur une face (108) d'un substrat (104, 106) et recouvrant au moins une partie (109) de la face (108) du substrat (104, 106) qui n'est pas disposée dans la cavité (120) et adjacente à la partie (107) de la face (108) du substrat (104, 106) disposée dans la cavité (120), la couche capot (112) comportant des flancs latéraux (114) formant, avec une partie (107) de la face (108) du substrat (104, 106) disposée dans la cavité (120), au moins un angle inférieur à 90°, au moins un trou (116) étant réalisé à travers au moins un des flancs latéraux (114) de la couche capot (112) tel qu'une distance maximale, selon un axe perpendiculaire à ladite face (108) du substrat (104, 106), entre ladite face (108) du substrat (104, 106) et au moins un bord (117) du trou (116) se trouvant du côté d'une face (113) de la couche capot (112) formant une paroi de la cavité (120), soit inférieure à environ 3 µm, le trou (116) traversant une partie (118) de la couche capot (112) déposée sur la partie (109) de la face (108) du substrat (104, 106) qui est n'est pas disposée dans la cavité (120), au moins un matériau (122, 124, 126) bouchant de manière étanche le trou (116).

15. Cavité (120) selon la revendication 14, dans laquelle une partie sommitale (115) de la couche capot (112) est conservée sans trou.

16. Cavité (120) selon l'une des revendications 14 ou 15, dans laquelle la valeur de l'angle formé par les flancs latéraux (114) de la couche capot (112) avec la partie (107) de la face (108) du substrat (104, 106) disposée dans la cavité (120) est comprise entre environ 5° et 30°.

17. Cavité (120) selon la revendication 15, dans laquelle une distance entre la partie sommitale (115) de la couche capot (112) et le substrat (104, 106) est comprise entre environ 0,5 µm et 1 µm, et la valeur de l'angle formé par les flancs latéraux (114) de la couche capot (112) avec la partie (107) de la face (108) du substrat (104, 106) disposée dans la cavité (120) est comprise entre environ 45° et 90°.

18. Cavité (120) selon l'une des revendications 14 à 17, dans laquelle au moins un dispositif microélectronique (100) est encapsulé de manière étanche dans la cavité (120).

19. Cavité (120) selon l'une des revendications 14 à 17, ladite cavité (120) formant un canal de circulation de fluides liquides ou gazeux.

## Patentansprüche

1. Verfahren zur Herstellung von wenigstens einem dichten Hohlraum (120), umfassend wenigstens die folgenden Schritte:
a) Herstellung einer Opferschicht (102) auf einem Abschnitt (107) einer Oberfläche (108) eines Substrats (104, 106),
b) Herstellung einer Deckschicht (112), welche wenigstens die Opferschicht (102) und einen Abschnitt (109) von der Oberfläche (108) des Substrats (104, 106) bedeckt, der nicht durch die Opferschicht (102) bedeckt ist, und der dem Abschnitt (107) der Oberfläche (108) des Substrats (104, 106) benachbart ist, der durch die Opferschicht (102) bedeckt ist, wobei die Deckschicht (112) seitliche Flanken (114) umfasst, die mit dem Abschnitt (107) der Oberfläche (108) des Substrats (104, 106), der durch die Opferschicht (102) bedeckt ist, wenigstens einen Winkel bilden, der kleiner als 90° ist,
c) Herstellung von wenigstens einem Loch (116) durch wenigstens eine der seitliche Flanken (114) der Deckschicht (112), so dass eine maximale Distanz, entlang einer Achse senkrecht zu der Oberfläche (108) des Substrats (104, 106), zwischen der Oberfläche (108) des Substrats (104, 106) und wenigstens einem Rand (117) des Lochs (116), der sich auf der Seite einer Oberfläche (113) der Deckschicht (112) befindet, die auf der Opferschicht (102) angeordnet ist, kleiner als ungefähr 3 µm ist, wobei das Loch (116) einen Abschnitt (118) der Deckschicht (112) durchquert, der auf dem Abschnitt (109) der Oberfläche (108) des Substrats (104, 106) aufgebracht ist, der nicht durch die Opferschicht (102) bedeckt ist,
d) Eliminierung der Opferschicht (102) durch das Loch (116) hindurch, wobei der durch diese Eliminierung freigewordene Raum den Hohlraum (120) bildet,
e) Aufbringen von wenigstens einem Material (122, 124, 126), welches in dichter Weise das Loch (116) verschließt.

2. Verfahren nach Anspruch 1, wobei ein Gipfel-Abschnitt (115) der Deckschicht (112) ohne Loch belassen wird.

3. Verfahren nach einem der vorhergehenden Ansprüche, wobei der Wert des Winkels, der durch die seitlichen Flanken (114) der Deckschicht (112) mit dem Abschnitt (107) der Oberfläche (108) des Substrats (104, 106) gebildet wird, der durch die Opferschicht (102) bedeckt ist, zwischen ungefähr 5° und 30° liegt.

4. Verfahren nach einem der Ansprüche 1 oder 2, wobei die Dicke der Opferschicht (102) zwischen ungefähr 0,5 µm und 1 µm liegt, und der Wert des Winkels, der durch die seitlichen Flanken (114) der Deckschicht (112) mit dem Abschnitt (107) der Oberfläche (108) des Substrats (104, 106) gebildet wird, der durch die Opferschicht (102) bedeckt ist, zwischen ungefähr 45° und 90° liegt.

5. Verfahren nach einem der Ansprüche 1 bis 3, wobei die maximale Distanz, entlang einer Achse senkrecht zu der Oberfläche (108) des Substrats (104, 106), zwischen der Oberfläche (108) des Substrats (104, 106) und den Rändern (117) des Lochs (116) zwischen ungefähr 1 µm und 3 µm liegt.

6. Verfahren nach einem der vorhergehenden Ansprüche, wobei der Schritt b) der Herstellung der Deckschicht (112) der Umsetzung, nach dem Schritt a) der Herstellung der Opferschicht (102), einer Formgebung der Opferschicht (102) entspricht, so dass die seitlichen Flanken (110) der Opferschicht (102) mit dem Abschnitt (107) der Oberfläche (108) des Substrats (104, 106), der durch die Opferschicht (102) bedeckt ist, den Winkel bilden, der kleiner als 90° ist, und dann einem entsprechenden Aufbringen der Deckschicht (112) wenigstens auf der Opferschicht (102) entspricht

7. Verfahren nach einem der vorhergehenden Ansprüche, wobei das im Schritt c) hergestellte Loch (116) in einer Ebene der Oberfläche (113) der Deckschicht (112), die auf der Opferschicht (102) angeordnet ist, einen Querschnitt mit Abmessungen umfasst, die kleiner als diejenigen von einem Querschnitt des Lochs (116) in einer Ebene von einer zweiten Oberfläche der Deckschicht (112) sind, die der Oberfläche (113) gegenüber liegt, welche auf der Opferschicht (102) angeordnet ist.

8. Verfahren nach einem der vorhergehenden Ansprüche, wobei der Schritt e) des Aufbringens des Materials (122, 124, 126), welches in dichter Weise das Loch (116) verschließt, unter reduziertem Druck oder im Vakuum durchgeführt wird.

9. Verfahren nach einem der vorhergehenden Ansprüche, wobei der Schritt e) des Aufbringens des Materials (124, 126), das in dichter Weise das Loch (116) verschließt, die Durchführung von einem ersten Aufbringen von wenigstens einem ersten Material (124), das das Loch (116) teilweise verschließt, und von einem zweiten Aufbringen von wenigstens einem zweiten Material (126) umfasst, welches wenigstens teilweise das erste Material (124) abdeckt und in dichter Weise das Loch (116) verschließt.

10. Verfahren nach einem der vorhergehenden Ansprüche, wobei das im Schritt c) hergestellte Loch (116) in einer Ebene einer Oberfläche der Deckschicht (112) einen Querschnitt mit im Wesentlichen kreisförmiger oder länglicher Form umfasst.

11. Verfahren nach einem der vorhergehenden Ansprüche, wobei vor dem Schritt a) ein mikroelektronisches Bauteil (100) auf oder in dem Abschnitt (107) der Oberfläche (108) des Substrats (104, 106) hergestellt wird, der dazu bestimmt ist, durch die Opferschicht (102) bedeckt zu werden, wobei das mikroelektronische Bauteil (100) in dichter Weise in dem Hohlraum (120) eingekapselt ist, nachdem der Schritt e) des Aufbringens von Material (122, 124, 126) durchgeführt wurde, welches in dichter Weise das Loch (116) verschließt.

12. Verfahren nach Anspruch 11, wobei das mikroelektronische Bauteil (100) vom MEMS-Typ ist.

13. Verfahren nach einem der vorhergehenden Ansprüche, wobei der Hohlraum (120) einen Kanal zur Zirkulation von flüssigen oder gasförmigen Fluiden bildet.

14. Dichter Hohlraum (120), gebildet durch wenigstens eine Deckschicht (112), die auf einer Oberfläche (108) eines Substrats (104, 106) angeordnet ist und wenigstens ein Abschnitt (109) der Oberfläche (108) des Substrats (104, 106) bedeckt, der nicht in dem Hohlraum (120) angeordnet ist und dem Abschnitt (107) der Oberfläche (108) des Substrats (104, 106) benachbart ist, der in dem Hohlraum (120) angeordnet ist, wobei die Deckschicht (112) seitliche Flanken (114) umfasst, die mit einem Abschnitt (107) der Oberfläche (108) des Substrats (104, 106), der in dem Hohlraum (120) angeordnet ist, wenigstens einen Winkel von kleiner als 90° bilden, wobei wenigstens ein Loch (116) durch wenigstens eine der seitlichen Flanken (114) der Deckschicht (112) hindurch so ausgeführt ist, dass eine maximale Distanz, entlang einer Achse senkrecht zu der Oberfläche (108) des Substrats (104, 106), zwischen der Oberfläche (108) des Substrats (104, 106) und wenigstens einem Rand (117) des Lochs (116), der sich auf der Seite einer Oberfläche (113) der Deckschicht (112) befindet, die eine Wand des Hohlraums (120) bildet, kleiner als ungefähr 3 µm ist, wobei das Loch (116) einen Abschnitt (118) der Deckschicht (112) durchquert, der auf dem Abschnitt (109) der Oberfläche (108) des Substrats (104, 106) aufgebracht ist, der nicht in dem Hohlraum (120) angeordnet ist, wobei wenigstens ein Material (122, 124, 126) in dichter Weise das Loch (116) verschließt.

15. Hohlraum (120) nach Anspruch 14, wobei ein Gipfel-Abschnitt (115) der Deckschicht (112) ohne Loch belassen ist.

16. Hohlraum (120) nach einem der Ansprüche 14 oder 15, wobei der Wert des Winkels, der durch die seitlichen Flanken (114) der Deckschicht (112) mit dem Abschnitt (107) der Oberfläche (108) des Substrats (104, 106), der in dem Hohlraum (120) angeordnet ist, gebildet wird, zwischen ungefähr 5° und 30° liegt.

17. Hohlraum (120) nach Anspruch 15, wobei eine Distanz zwischen dem Gipfel-Abschnitt (115) der Deckschicht (112) und dem Substrat (104, 106) zwischen ungefähr 0,5 µm und 1 µm liegt, und der Wert des Winkels, der durch die seitlichen Flanken (114) der Deckschicht (112) mit dem Abschnitt (107) der Oberfläche (108) des Substrats (104, 106) gebildet wird, der in dem Hohlraum (120) angeordnet ist, zwischen ungefähr 45° und 90° liegt.

18. Hohlraum (120) nach einem der Ansprüche 14 bis 17, wobei wenigstens ein mikroelektronisches Bauteil (100) in dichter Weise in dem Hohlraum (120) eingekapselt ist.

19. Hohlraum (120) nach einem der Ansprüche 14 bis 17, wobei der Hohlraum (120) einen Kanal für die Zirkulation von flüssigen oder gasförmigen Fluiden bildet.

## Claims

1. Method for production of at least one sealed cavity (120), including at least the following steps:
a) production of a sacrificial layer (102) on a portion (107) of one face (108) of a substrate (104, 106),
b) production of a cover layer (112) covering at least the sacrificial layer (102) and a portion (109) of the face (108) of the substrate (104, 106) not covered by the sacrificial layer (102) and adjacent to the portion (107) of the face (108) of the substrate (104, 106) covered by the sacrificial layer (102), where the cover layer (112) includes lateral flanks (114) forming, with the portion (107) of the face (108) of the substrate (104, 106) covered by the sacrificial layer (102), at least an angle of less than 90°,
c) production of at least one hole (116) through at least one of the lateral flanks (114) of the cover layer (112) such that a maximum distance, along an axis perpendicular to the said face (108) of the substrate (104, 106), between the said face (108) of the substrate (104, 106) and at least one edge (117) of the hole (116) located on the side of a face (113) of the cover layer (112) positioned against the sacrificial layer (102), is less than approximately 3 µm, where the hole (116) crosses a portion (118) of the cover layer (112) positioned on the portion (109) of the face (108) of the substrate (104, 106) which is not covered by the sacrificial layer (102),
d) elimination of the sacrificial layer (102) through the hole (116), where the space released by this elimination forms the cavity (120),
e) deposit of at least one material (112, 124, 126) plugging the hole (116) in a sealed fashion.

2. Method according to claim 1, in which an uppermost portion (115) of the cover layer (112) is kept without holes.

3. Method according to one of previous claims, in which the value of the angle formed by the lateral flanks (114) of the cover layer (112) with the portion (107) of the face (108) of the substrate (104, 106) covered by the sacrificial layer (102) is between approximately 5° and 30°.

4. Method according to one of claims 1 or 2, in which the thickness of the sacrificial layer (102) is between approximately 0.5 µm and 1 µm and the value of the angle formed by the lateral flanks (114) of the cover layer (112) with the portion (107) of the face (108) of the substrate (104, 106) covered by the sacrificial layer (102) is between approximately 45° and 90°.

5. Method according to one of claims 1 to 3, in which the maximum distance, along an axis perpendicular to the said face (108) of the substrate (104, 106), between the said face (108) of the substrate (104, 106) and the edges (117) of the hole (116) is between approximately 1 µm and 3 µm.

6. Method according to one of previous claims, in which step b) of production of the cover layer (112) is the implementation, after step a) of production of the sacrificial layer (102), of a shaping of the sacrificial layer (102) such that lateral flanks (110) of the sacrificial layer (102) form, with the portion (107) of the face (108) of the substrate (104, 106) covered by the sacrificial layer (102), the angle of less than 90°, followed by a conformal deposit of the cover layer (112) at least on the sacrificial layer (102).

7. Method according to one of previous claims, in which the hole (116) produced in step c) includes, in a plane of the face (113) of the cover layer (112) positioned against the sacrificial layer (102), a section of dimensions less than those of a section of the hole (116) in a plane of a second face of the cover layer (112) opposite the said face (113) positioned against the sacrificial layer (102).

8. Method according to one of previous claims, in which step e) of deposit of the material (122, 124, 126) plugging the hole (116) in sealed fashion is implemented under low pressure or under vacuum.

9. Method according to one of previous claims, in which step e) of deposit of the material (124, 126) plugging the hole (116) in sealed fashion includes the implementation of a first deposit of at least a first material (124) partially plugging the hole (116), and of a second deposit of at least a second material (126) covering the first material (124) at least partly, and plugging the hole (116) in sealed fashion.

10. Method according to one of previous claims, in which the hole (116) produced in step c) includes, in a plane of a face of the cover layer (112), a section of roughly circular or oblong shape.

11. Method according to one of previous claims, in which, prior to step a), a microelectronic device (100) is produced on or in the said portion (107) of the face (108) of the substrate (104, 106) intended to be covered by the sacrificial layer (102), where the said microelectronic device (100) is encapsulated in sealed fashion in the cavity (120) after implementation of step e) of deposit of the material (122, 124, 126) plugging the hole (116) in sealed fashion.

12. Method according to claim 11, in which the microelectronic device (100) is of the MEMS type.

13. Method according to one of previous claims, in which the cavity (120) forms a channel for the passage of liquid or gaseous fluids.

14. A sealed cavity (120) formed by at least one cover layer (112) positioned on a face (108) of a substrate (104, 106) and covering at least a portion (109) of the face (108) of the substrate (104, 106) which is not positioned in the cavity (120) and adjacent to the portion (107) of the face (108) of the substrate (104, 106) positioned in the cavity (120), where the cover layer (112) includes lateral flanks (114) forming, with a portion (107) of the face (108) of the substrate (104, 106) positioned in the cavity (120), at least an angle of less than 90°, where at least one hole (116) is produced through at least one of the lateral flanks (114) of the cover layer (112) such that a maximum distance, along an axis perpendicular to the said face (108) of the substrate (104, 106), between the said face (108) of the substrate (104, 106) and at least one edge (117) of the hole (116) located on the side of a face (113) of the cover layer (112) forming a wall of the cavity (120), is less than approximately 3 µm, where the hole (116) crosses a portion (118) of the cover layer (112) deposited on the portion (109) of the face (108) of the substrate (104, 106) which is not positioned in the cavity (120), and where at least one material (122, 124, 126) plugs the hole (116) in sealed fashion.

15. Cavity (120) according to claim 14, in which an uppermost portion (115) of the cover layer (112) is kept without holes.

16. Cavity (120) according to one of claims 14 or 15, in which the value of the angle formed by the lateral flanks (114) of the cover layer (112) with the portion (107) of the face (108) of the substrate (104, 106) positioned in the cavity (120) is between approximately 5° and 30°.

17. Cavity (120) according to claim 15, in which a distance between the uppermost portion (115) of the cover layer (112) and the substrate (104, 106) is between approximately 0.5 µm and 1 µm, and the value of the angle formed by the lateral flanks (114) of the cover layer (112) with the portion (107) of the face (108) of the substrate (104, 106) positioned in the cavity (120) is between approximately 45° and 90°.

18. Cavity (120) according to one of claims 14 to 17, in which at least one microelectronic device (100) is encapsulated in the cavity (120) in sealed fashion.

19. Cavity (120) according to one of claims 14 to 17, where said cavity (120) forms a channel for passage of liquid or gaseous fluids.
